(19) Europäisches Patentamt / European Patent Office / Office européen des brevets

(11) **EP 3 002 898 B1**

(12) **EUROPEAN PATENT SPECIFICATION**

(45) Date of publication and mention
of the grant of the patent:
**31.05.2017 Bulletin 2017/22**

(21) Application number: **14197276.0**

(22) Date of filing: **11.12.2014**

(51) Int Cl.:
*H04L 1/00* (2006.01)    *H03M 13/11* (2006.01)
*H03M 13/25* (2006.01)    *H03M 13/27* (2006.01)

(54) **Decoding device**

Decodierungsvorrichtung

Dispositif de décodage

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.09.2014 CN 201410522373**

(43) Date of publication of application:
**06.04.2016 Bulletin 2016/14**

(73) Proprietor: **ALi Corporation
Hsinchu City 300 (TW)**

(72) Inventor: **Li, Lin
200233 Shanghai (CN)**

(74) Representative: **Viering, Jentschura & Partner
mbB
Patent- und Rechtsanwälte
Kennedydamm 55 / Roßstrasse
40476 Düsseldorf (DE)**

(56) References cited:
**EP-A1- 2 525 495**

• **MENG LI ET AL: "A shuffled iterative
bit-interleaved coded modulation receiver for the
DVB-T2 standard: Design, implementation and
FPGA prototyping", SIGNAL PROCESSING
SYSTEMS (SIPS), 2011 IEEE WORKSHOP ON,
IEEE, 4 October 2011 (2011-10-04), pages 55-60,
XP032029125, DOI: 10.1109/SIPS.2011.6088949
ISBN: 978-1-4577-1920-2**
• **TAKASHI YOKOKAWA ET AL: "Parity and column
twist bit interleaver for DVB-T2 LDPC codes",
TURBO CODES AND RELATED TOPICS, 2008
5TH INTERNATIONAL SYMPOSIUM ON, IEEE,
PISCATAWAY, NJ, USA, 1 September 2008
(2008-09-01), pages 123-127, XP031353674, DOI:
10.1109/TURBOCODING.2008.4658684 ISBN:
978-1-4244-2862-5**

Printed by Jouve, 75001 PARIS (FR)

**Description**

BACKGROUND

1. Technical Field

The present disclosure relates to a communication system; in particular, to an iterative de-mapping and decoding device used in a digital video broadcasting- second generation terrestrial (DVB-T2) system.

2. Description of Related Art

The decoding device of the communication can use an iterative calculation to obtain a log likelihood ratio (LLR) of each bit of the symbol, so as to solve a bit value of each bit of the symbol received by the decoding device. For example, a DVB-T2 standard specifies a calculating equation of LLR associated with the bit $b_i$ as follows:

$$LLR(b_i) \approx \min_{x \in C_i^0} \left( \frac{(I - \rho_I I_x)^2 + (Q - \rho_Q Q_x)^2}{2\sigma^2} - \sum_{k \neq i \ and \ x_k = 1} LLR_{EXT}(b_k) \right)$$

$$- \min_{x \in C_i^1} \left( \frac{(I - \rho_I I_x)^2 + (Q - \rho_Q Q_x)^2}{2\sigma^2} - \sum_{k \neq i \ and \ x_k = 1} LLR_{EXT}(b_k) \right)$$

, wherein $\rho_I$, and $\rho_Q$ are denoted as amplitude attenuation factors, $C_i^0$ is a constellation set which the bit $b_i$ is 0, $C_i^1$ is a constellation set which the bit $b_i$ is 1, LLREXT($b_k$) is a feedback LLR, and $x_k$ is the bit value of the bit $b_k$. To put it concretely, LLREXT($b_k$) is the differential LLR which the output LLR LLROUT($b_k$) of the bit $b_k$ output from the low density parity check (LDPC) decoder subtracts the input LLR LLRIN($b_k$) of the bit $b_k$ input into the LDPC decoder.

Generally, the transmitter can perform a bit interleaving process on the bits to be transmitted, and the receiver can perform a de-interleaving process on each bit of the de-mapped symbol, so as to solve the LLR of each de-interleaved bit. After the receiver solves the LLR of each bit, corresponding to the bit interleaving process, the receiver should process and permute feedback LLRs of the bits while the feedback LLRs of the bits are generated and feedbacked for the iterative calculation, such that the receiver can perform the iterative calculation correctly to the generated iterative LLRs. Currently, a receiver of the DVB-T2 system which can record the Euclidean distance between the symbol and each constellation point is proposed, and the receiver can perform the decoding process and the de-mapping process on the two different frames during the same clock. However, the manner must record the Euclidean distances between the symbol and the constellation points, thus causing the enormous hardware cost.

Additionally, another receiver of the DVB-T2 system is proposed. Corresponding to the column twist interleaving process, the receiver can use a look-up table (LUT) to permute the feedback LLRs before feedbacking the feedback LLRs for the iterative calculation, such that the permuted feedback LLRs can be feedbacked for the iterative calculation. However, the manner needs a massive storage space for storing the LUT, thus still causing the enormous hardware cost.

SUMMARY

An exemplary embodiment of the present disclosure provides an iterative de-mapping and decoding device comprising a first memory, a second memory, a reception control unit, a first buffer, a second buffer, a first memory control unit, a second memory control unit, and a de-map processing unit. The reception control unit is coupled to the first memory, the first memory control unit is coupled to the first memory and the first buffer, the second memory control unit is coupled to the second memory and the second buffer, and the de-map processing unit is coupled to the first buffer and the second buffer. The reception control unit sequentially stores in-phase signal values, quadrature signal values, and pieces of channel state information in the first memory. The first memory control unit calculates first addresses, and accordingly parallel buffers the M in-phase signal values, the M quadrature signal values, and the M pieces of channel state information of M symbols stored in the first memory to first buffer. The second memory control unit parallel stores each M first feedback LLRs generated from a LDPC decoder in the second memory, and calculating second addresses to accordingly buffer M·(N-1) first feedback LLRs stored in the second memory to the second buffer. The de-map processing unit reads the M·(N-1) first feedback LLRs from the second buffer, reads the K in-phase signal values, the K quadrature signal values, and the K pieces of the channel state information from the first buffer, and solves a LLR of each of M specific bits according to the M·(N-1) first feedback LLRs, the K in-phase signal values, the K quadrature signal values, and the K pieces of the channel state information, wherein M is a number of the first feedback LLRs once generated by the LDPC decoder, N is a bit number of the symbol, and K is an integer less than or equal to M.

To sum up, compared with the conventional iterative de-mapping and decoding device, see e.g. EP 2 525 495 A1, the iterative de-mapping and decoding device provided by an exemplary embodiment of the present disclosure has little hardware cost, and can be implemented simply.

In order to further understand the techniques, means and effects of the present disclosure, the following detailed descriptions and appended drawings are hereby referred, such that, through which, the purposes, features and aspects of the present disclosure can be thoroughly and concretely appreciated; however, the appended drawings are merely provided for reference and illustration, without any intention to be used for limiting the present disclosure, which is limited only by the appended claims. Embodiments that do not fall under the scope of the claims are useful for understanding the invention.

BRIEF DESCRIPTION OF THE DRAWINGS

The accompanying drawings are included to provide a further understanding of the present disclosure, and are incorporated in and constitute a part of this specification. The drawings illustrate exemplary embodiments of the present disclosure and, together with the description, serve to explain the principles of the present disclosure.

FIG. 1 is a block diagram of an iterative de-mapping and decoding device according to an exemplary embodiment of the present disclosure.

FIG. 2 is schematic diagram showing a pipe line process performed by an iterative de-mapping and decoding device according to an exemplary embodiment of the present disclosure.

FIG. 3 is a schematic diagram showing LLRs of bits associated with a frame stored in a LDPC decoder according to an exemplary embodiment of the present disclosure.

FIG. 4 is an equivalent block diagram of an iterative de-mapping and decoding device adopting a 16-QAM, 64-QAM, or 256-QAM modulation scheme according to an exemplary embodiment of the present disclosure.

FIG. 5 is a schematic diagram showing a column twist interleaving process performed on first or second feedback LLRs according to an exemplary embodiment of the present disclosure.

FIG. 6 is a schematic diagram showing a bit-symbol multiplexing process performed on first or second feedback LLRs according to an exemplary embodiment of the present disclosure.

FIG. 7 is an equivalent block diagram of an iterative de-mapping and decoding device adopting a QPSK modulation scheme with a 1/3 or 2/5 coding rate according to an exemplary embodiment of the present disclosure.

FIG. 8 is a schematic diagram showing a bit-symbol multiplexing process performed on first or second feedback LLRs according to one other exemplary embodiment of the present disclosure.

FIG. 9 is an equivalent block diagram of an iterative de-mapping and decoding device adopting a QPSK modulation scheme with one other coding rate (without the 1/3 and 2/5 coding rate) according to an exemplary embodiment of the present disclosure.

FIG. 10 is a schematic diagram showing a parity de-interleaving process and a bit-symbol multiplexing process performed on first or second feedback LLRs of the parity part according to an exemplary embodiment of the present disclosure.

FIG. 11A is a schematic diagram showing a data reading process of the first memory according to an exemplary embodiment of the present disclosure.

FIG. 11B is a schematic diagram showing that a first memory is divided to several first memory group blocks according to an exemplary embodiment of the present disclosure.

DESCRIPTION OF THE EXEMPLARY EMBODIMENTS

Reference will now be made in detail to the exemplary embodiments of the present disclosure, examples of which are illustrated in the accompanying drawings. Wherever possible, the same reference numbers are used in the drawings and the description to refer to the same or similar parts.

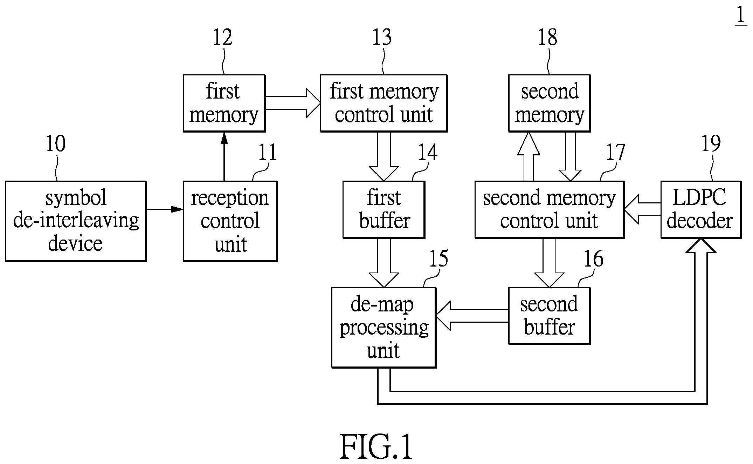

Referring to FIG. 1, FIG. 1 is a block diagram of an iterative de-mapping and decoding device according to an exemplary embodiment of the present disclosure. The iterative de-mapping and decoding device 1 can be used in a receiver of a communication system, particularly a receiver of a digital video broadcasting system, such as a receiver of a DVB-T2 system. The iterative de-mapping and decoding device 1 comprises a reception control unit 11, a first memory 12, a first memory control unit 13, a first buffer 14, a de-map processing unit 15, a second buffer 16, a second memory control unit 17, and a second memory 18. The iterative de-mapping and decoding device 1 can further comprise a symbol de-interleaving device 10 and a LDPC decoder 19, and the present disclosure is not limited thereto. The symbol de-interleaving device 10 and the LDPC decoder 19 may be disposed outside the iterative de-mapping and decoding device 1, and electrically connected to the iterative de-mapping and decoding device 1.

In the exemplary embodiment, the reception control unit 11 is electrically connected to the symbol de-interleaving device 10, and the first memory 12 is electrically connected to the reception control unit 11. The first memory control unit 13 is electrically connected to the first buffer 14, and the de-map processing unit 15 is electrically first buffer 14. The second buffer 16 is electrically connected to the de-map processing unit 15, and the second memory control unit 17 is electrically connected to the second buffer 16. The second memory 18 is electrically connected to the second memory control unit 17, the LDPC decoder 19 is electrically connected to the second memory control unit 17 and the de-map processing unit 15.

The symbol de-interleaving device 10 is used to receive a frame comprising symbols, such as a forward correction error (FEC) frame, and perform a symbol de-interleaving process on the symbols, so as to output in-phase signal values, quadrature signal values, and pieces of channel state information of the symbols on which the symbol de-interleaving process is performed. The reception control unit 11 is used to sequentially store the in-phase signal values, the quadrature signal values, and the pieces of the channel state information of the symbols on which the symbol de-interleaving process is performed to the first memory 12. The first memory control unit 13 calculates first addresses, reads the M in-phase signal values, the M quadrature signal values, and the M pieces of channel state information of the M symbols according to the first addresses, and then buffers them to the first buffer 14, wherein M is a number of the first feedback LLRs once generated by the LDPC decoder 19, for example 360.

The LDPC decoder 19 receives LLRs of the M bits, and output first feedback LLRs of the M bits accordingly, for example, the feedback LLRs $LLR_{EXT}(b_k)$ of the bit bk. The second memory control unit 17 is used to parallel store each M first feedback LLRs generated by the LDPC decoder 19 in the second memory 18, and calculates second addresses. The second memory control unit 17 can read the M·(N-1) first feedback LLRs stored in the second memory according to the second addresses, and then buffer them to the second buffer 16, wherein N is a bit number of one symbol, for example N is equal to 8 while the 256-QAM modulation scheme is adopted.

The de-map processing unit 15 is used to read the M·(N-1) first feedback LLRs from the second buffer 16, and read the K in-phase signal values, the K quadrature signal values, and the K pieces of the channel state information from the first buffer 14. Then, the de-map processing unit 15 solves the LLR of each of the M specific bits according to the M·(N-1) first feedback LLRs, the K in-phase signal values, the K quadrature signal values, and the K pieces of the channel state information, wherein K is an integer less than or equal to M. When a 16-QAM, 64-QAM, or 256-QAM modulation scheme is adopted, K is equal to M, and each of the M specific bits is one bit of each of M symbols. When the QPSK modulation scheme is adopted regardless of the coding rate, K is equal to M/2, and the M specific bits are all bits of the K symbols.

Simply, the standard adopted by the communication system specifies that the transmitter performs a column twist interleaving process, a bit-symbol multiplexing process, and/or a parity de-interleaving process on the symbols according to the modulation scheme and the coding rate. Thus, the receiver must permute the first feedback LLRs corresponding to the column twist interleaving process, the bit-symbol multiplexing process, and/or the parity de-interleaving process. The iterative de-mapping and decoding device 1 according to the exemplary embodiment of the present disclosure uses a simple address calculating manner to access the first feedback LLRs accordingly, such that the first feedback LLRs are equivalently permuted and buffered in the second buffer 16 corresponding to the column twist interleaving process, the bit-symbol multiplexing process, and/or the parity de-interleaving process. Therefore, the hardware associated with the column twist interleaving device, the bit-symbol multiplexer, and/or the parity interleaving device can be saved, without using a massive storage device to store the LUT.

On the other hand, the de-map processing unit 15 uses he K in-phase signal values, the K quadrature signal values, and the K pieces of the channel state information to solve the LLRs of the M specific bits, and thus the iterative de-mapping and decoding device 1 does not need to record the Euclidean distance between the symbol and each constellation point, and massive storage space can be saved.

Even, the de-map processing unit 15 can use a hybrid calculating manner with soft and hard decision, wherein at least one particular bit is determined by the hard decision previously, and the number of the constellation points to be calculated is reduced to decrease the whole computation. Thus, the second memory control unit 17 may further parallel stores each M second feedback LLRs generated from the LDPC decoder 19 in the second memory 18, and calculate third addresses. The second memory control unit 17 reads the M·(N-1) second feedback LLRs stored in the second memory 18 according to the third addresses, and buffers them to the second buffer 16. Then, the de-map processing unit 15 further reads the M·(N-1) second feedback LLRs from the second buffer 16, and solves the LLRs of the M specific bits according to the M·(N-1) first feedback LLRs, the M·(N-1) second feedback LLRs, the K in-phase signal values, the K quadrature signal values, and the K pieces of the channel state information.

Preferably, the iterative de-mapping and decoding device 1 may adopt a pipe line process to perform different processes on the different frames at the same time, and the present disclosure is not limited thereto. Referring to FIG.

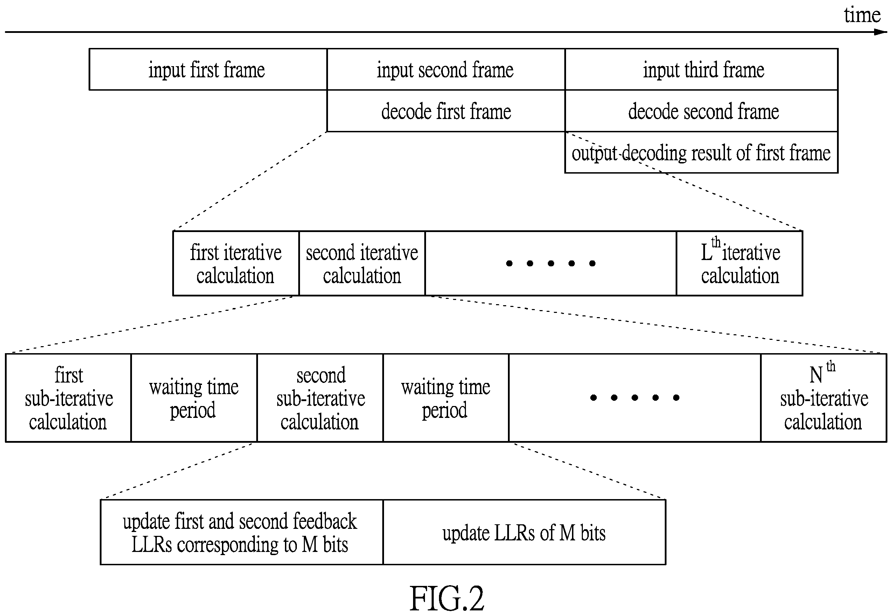

1 and FIG. 2, FIG. 2 is schematic diagram showing a pipe line process performed by an iterative de-mapping and decoding device according to an exemplary embodiment of the present disclosure. The iterative de-mapping and decoding device may receive an first frame input therein during several cycles, and that is, the 1 reception control unit 11 sequentially stores the in-phase signal values, the quadrature signal values, and the pieces of the channel state information associated with symbols in the first frame on which the symbol de-interleaving process is performed in the first memory 12.

In the next cycles, the iterative de-mapping and decoding device 1 can receive the second frame input therein and decode the first frame at the same time. That is, at the same time, the reception control unit 11 sequentially stores the in-phase signal values, the quadrature signal values, and the pieces of the channel state information associated with symbols in the second frame on which the symbol de-interleaving process is performed in the first memory 12, and the first memory control unit 13, the first buffer14, the second memory control unit 17, the second buffer 16, and the de-map processing unit 15 collaborate to perform the iterative calculation L times on each bit of the symbol in the first frame, so as to obtain the LLR of each bit on which iterative calculation is performed on L times.

In the next cycles, the iterative de-mapping and decoding device 1 can receive the third frame input therein and decode the second frame at the same time. That is, at the same time, the reception control unit 11 sequentially stores the in-phase signal values, the quadrature signal values, and the pieces of the channel state information associated with symbols in the third frame on which the symbol de-interleaving process is performed in the first memory 12, and the first memory control unit 13, the first buffer14, the second memory control unit 17, the second buffer 16, and the de-map processing unit 15 collaborate to perform the iterative calculation L times on each bit of the symbol in the second frame, so as to obtain the LLR of each bit on which iterative calculation is performed on L times. Meanwhile, the LDPC decoder 19 outputs the decoding result of the first frame to the rear block, such as a BCH decoder.

It is noted that, each iterative calculation may comprise several sub-iterative calculations. Each two continuous sub-iterative calculations have one waiting time period therebetween, and during one sub-iterative calculation and one waiting time period, the M first feedback LLRs and M second feedback LLRs of the M specific bits are updated, and then the LLRs of the M specific bits are updated according to the M first feedback LLRs and M second feedback LLRs of the M specific bits.

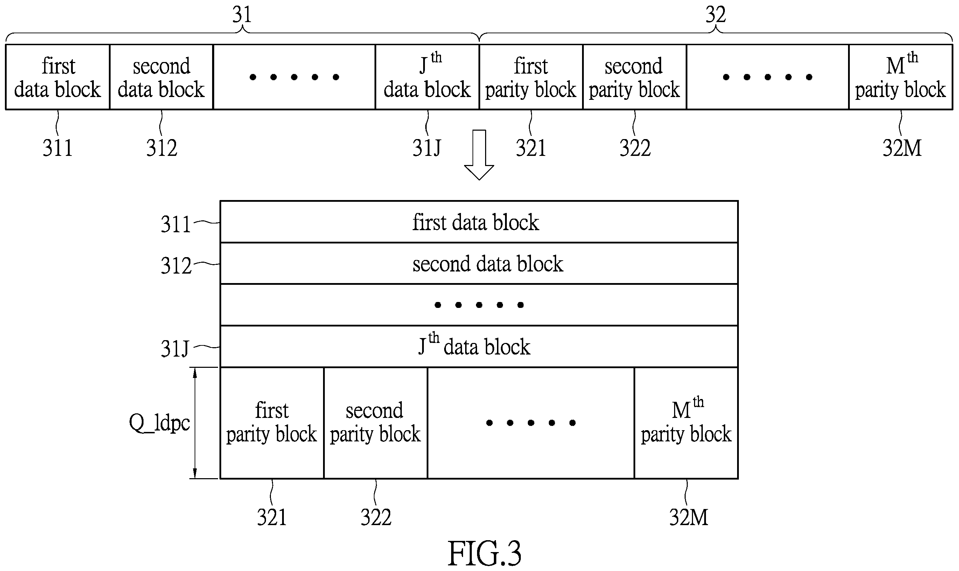

Referring to FIG. 3, FIG. 3 is a schematic diagram showing LLRs of bits associated with a frame stored in a LDPC decoder according to an exemplary embodiment of the present disclosure. The LLRs of all bits in the frame can be divided to an information part 31 and a parity part 32, wherein the information part 31 comprises data blocks 311 through 31J, and the parity part comprises parity blocks 321 through 32M. Each of the data blocks 311 through 31J comprises M first feedback LLRs (and M second feedback LLRs), and each of the parity blocks 321 through 32M has $Q\_ldpc$ first feedback LLRs (or $Q\_ldpc$ second feedback LLRs), wherein $Q\_ldpc$ is a parameter related to a coding rate of LDPC coding. In the LDPC decoder, regarding the information part 31, the data blocks 311 through 31J are stored in the same storage unit, and therefore a data block can be processed s parallel, that is, the data with the same address in the memory is accessed (i.e. read and written). Regarding the parity part 32, the parity blocks 321 through 32M are stored in the $Q\_ldpc$ storage units (as shown in FIG. 3), and thus the $P^{th}$ feedback LLRs of the parity blocks 321 through 32M are processed parallel since they are stored in the same storage unit, wherein P is an integer from 1 through M. The first feedback LLRs and the second feedback LLRs output from the LDPC decoder are solved according to the data stored in the memory, and thus the LDPC decoder output all data of one storage unit each time. Regarding the information part 31, the order of the read operation is the same as the order of the write operation. However, regarding the parity part 32, a column-in and row-out mode is adopted, and thus a column twist interleaving process is performed. That is, when the LDPC decoder outputs first feedback LLRs and the second feedback LLRs, the parity part 32 is equivalently performed with a column twist interleaving process.

Thus, via the write operation and the read operation of the LDPC decoder, and further via the modulation scheme and the coding rate, a simple address calculation is utilized to equivalently permute the first feedback LLRs and the second feedback LLRs corresponding to a column twist interleaving process, a bit-symbol multiplexing process, and/or a parity interleaving process. The following examples with different modulation schemes and coding rates are given to illustrate how the first feedback LLRs and the second feedback LLRs are equivalently permuted in the second buffer according to the column twist interleaving process, the bit-symbol multiplexing process, and/or the parity interleaving process.

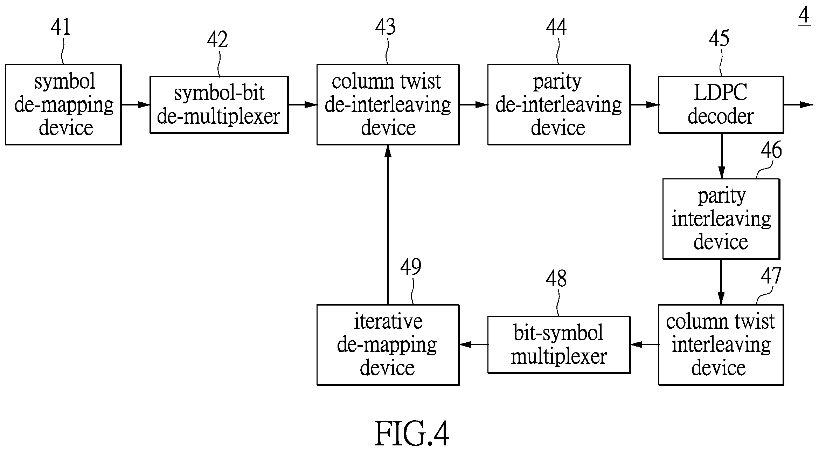

Referring to FIG. 4, FIG. 4 is an equivalent block diagram of an iterative de-mapping and decoding device adopting a 16-QAM, 64-QAM, or 256-QAM modulation scheme according to an exemplary embodiment of the present disclosure. When the 16-QAM, 64-QAM, or 256-QAM modulation scheme is adopted, the iterative de-mapping and decoding device 1 in FIG. 1 can be equivalently the same as the iterative de-mapping and decoding device 4 in FIG. 4. The equivalent iterative de-mapping and decoding device 4 comprises a symbol de-mapping device 41, a symbol-bit de-multiplexer 42, a column twist de-interleaving device 43, a parity de-interleaving device 44, a LDPC decoder 45, a parity interleaving device 46, a column twist interleaving device 47, a bit-symbol multiplexer 48, and an iterative de-mapping device 49.

The LDPC decoder 45 outputs the M first feedback LLRs and the M second feedback LLRs to the iterative de-mapping device 49. The iterative de-mapping device 49 can solve M LLRs which are served as initial values of the M LLRs input to the LDPC decoder 45 the next time.

The M LLRs should not be permuted, but the M·(N-1) first feedback LLRs and the M·(N-1) second feedback LLRs output from the LDPC decoder should be permuted in the second buffer corresponding to the parity interleaving process, the column twist interleaving process, the bit-symbol multiplexing process since the transmitter performs a bit interleaving process (comprising a parity interleaving process and a column twist interleaving process).

It is noted that, since the LDPC decoder 45 and the parity interleaving device 46 may generally be integrated in one device, the M·(N-1) first feedback LLRs and the M·(N-1) second feedback LLRs should be permuted in the second buffer merely corresponding to the column twist interleaving process and the bit-symbol multiplexing process. That is, the second memory control unit calculates the second addresses and the third addresses to accordingly read the M·(N-1) first feedback LLRs and the M·(N-1) second feedback LLRs from the second memory, and then buffers them in the second buffer, such that the M·(N-1) first feedback LLRs and the M·(N-1) second feedback LLRs buffered in second buffer are thus permuted corresponding to the column twist interleaving process and the bit-symbol multiplexing process.

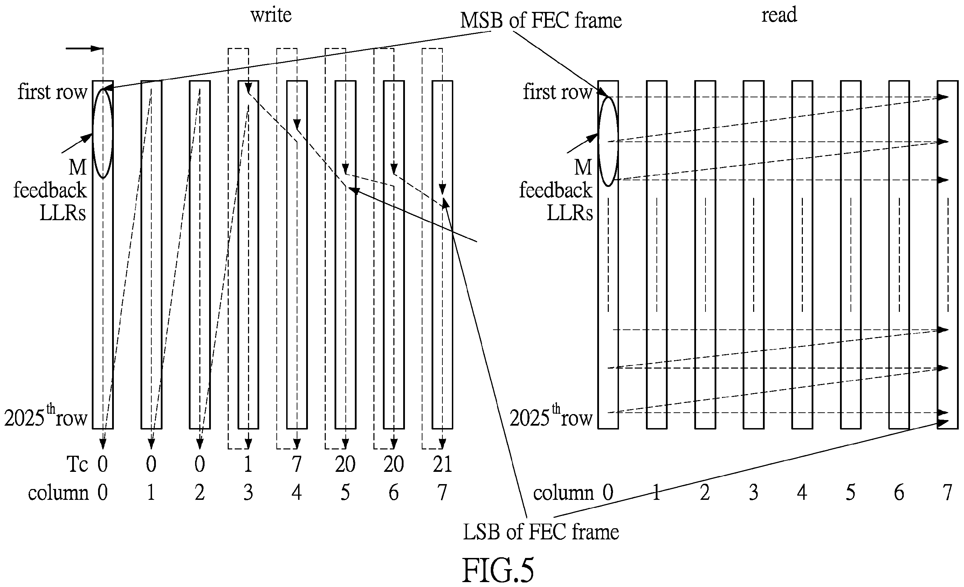

Referring to FIG. 5, FIG. 5 is a schematic diagram showing a column twist interleaving process performed on first or second feedback LLRs according to an exemplary embodiment of the present disclosure. The column twist interleaving process is used to parallel store the first feedback LLRs and the second feedback LLRs of the FEC frame to a first column through a last column (e.g. the seventh column) several times, wherein the M first feedback LLRs and the M second feedback LLRs are stored each time, and each column has one offset flag Tc to determine a storage start point of the column. Furthermore, during the read operation, the first feedback LLRs and the second feedback LLRs are read sequentially from the first row through the last row (e.g. the 2025th row).

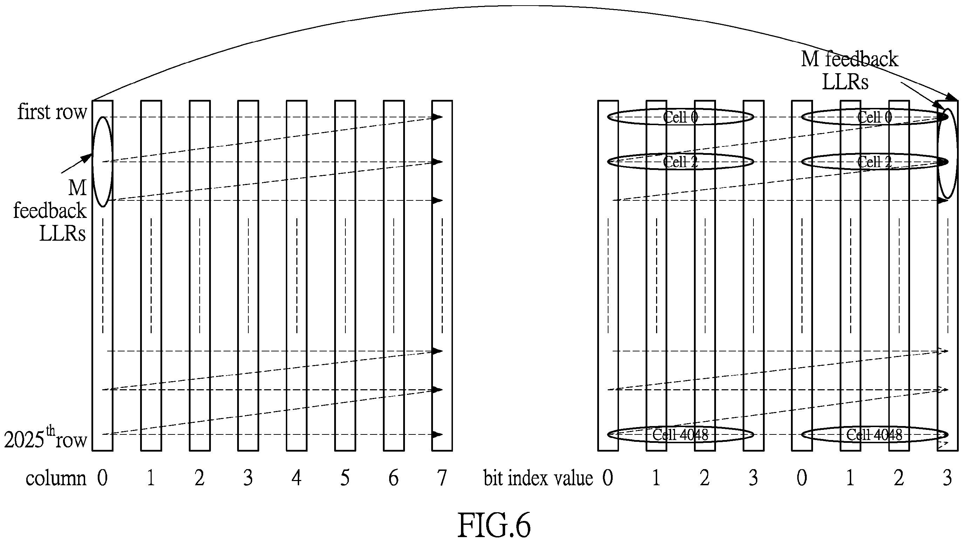

Referring to FIG. 6, FIG. 6 is a schematic diagram showing a bit-symbol multiplexing process performed on first or second feedback LLRs according to an exemplary embodiment of the present disclosure. From FIG. 6, the bit-symbol multiplexing process is used to exchange the columns being performed with the column twist interleaving process, for example the data of the 0th column and the 7th column are exchanged to each other.

Through the illustration of the column twist interleaving process and the bit-symbol multiplexing process, the second memory control unit is designed to calculate the second and third addresses according to the above processes, read the M·(N-1) first feedback LLRs and the M·(N-1) second feedback LLRs from the second memory according to the second and third addresses, and buffer them to the second buffer. In short, the iterative de-mapping and decoding device provided by the exemplary embodiment provided by the exemplary embodiment of the present disclosure can permute the M·(N-1) first feedback LLRs and the M·(N-1) second feedback LLRs without disposing the physical column twist interleaving device and the physical bit-symbol multiplexer.

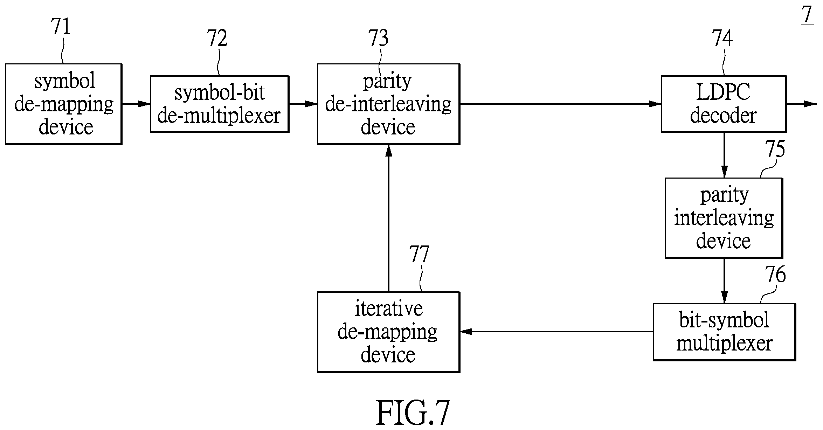

Referring to 7, FIG. 7 is an equivalent block diagram of an iterative de-mapping and decoding device adopting a QPSK modulation scheme with a 1/3 or 2/5 coding rate according to an exemplary embodiment of the present disclosure. When the QPSK modulation scheme with the 1/3 or 2/5 coding rate is adopted, the iterative de-mapping and decoding device 1 in FIG. 1 can be equivalently the same as the iterative de-mapping and decoding device 7 in FIG. 7. The equivalent iterative de-mapping and decoding device 7 comprises a symbol de-mapping device 71, symbol-bit de-multiplexer 72, a de-interleaving device 73, a LDPC decoder 74, a parity interleaving device 75, a bit-symbol multiplexer 76 and an iterative de-mapping device 77.

The LDPC decoder 74 outputs the M first feedback LLRs and the M second feedback LLRs to the iterative de-mapping device 77. The iterative de-mapping device 77 solves the M LLRs which are served as initial values of the M LLRs input to the LDPC decoder 75 the next time. The M·(N-1) LLRs should not be permuted, but the M·(N-1) first feedback LLRs and the M·(N-1) second feedback LLRs output form the LDPC decoder 74 should be permuted in the second buffer corresponding to the parity interleaving process and a bit-symbol multiplexing process since the transmitter performs a parity interleaving process.

It is noted that since the LDPC decoder 74 and the parity interleaving device 75 may generally be integrated in one device, the M·(N-1) first feedback LLRs and the M·(N-1) second feedback LLRs should be permuted in the second buffer merely corresponding to the bit-symbol multiplexing process. That is, the second memory control unit calculates the second and third addresses to accordingly read the M·(N-1) first feedback LLRs and the M·(N-1) second feedback LLRs from the second memory, and then buffers them in the second buffer, such that the M·(N-1) first feedback LLRs and the M·(N-1) second feedback LLRs buffered in second buffer are thus permuted corresponding to the bit-symbol multiplexing process.

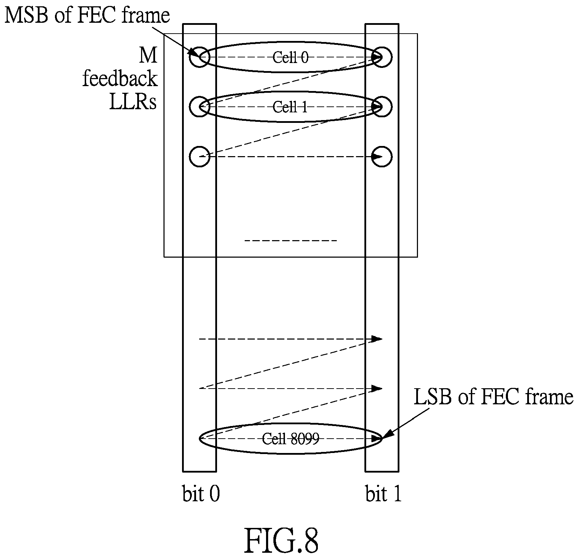

Referring to FIG. 8, FIG. 8 is a schematic diagram showing a bit-symbol multiplexing process performed on first or second feedback LLRs according to one other exemplary embodiment of the present disclosure. From FIG. 8, the bit-symbol multiplexing process is used to parallel store the first feedback LLRs and the second feedback LLRs of the FEC frame to a first column through a second column several times, wherein the M first feedback LLRs and the second feedback LLRs are stored each time. In other words, when the QPSK modulation scheme with the 1/3 or 2/5 coding rate is adopted, the bit-symbol multiplexing process does not exchange the columns.

Through the illustration of the bit-symbol multiplexing process, the second memory control unit is designed to calculate the second and third addresses according to the above process, read the M·(N-1) first feedback LLRs and the M·(N-1) second feedback LLRs from the second memory according to the second and third addresses, and buffer them to the second buffer. In short, the iterative de-mapping and decoding device provided by the exemplary embodiment provided by the exemplary embodiment of the present disclosure can permute the M·(N-1) first feedback LLRs and the M·(N-1) second feedback LLRs without disposing the physical bit-symbol multiplexer.

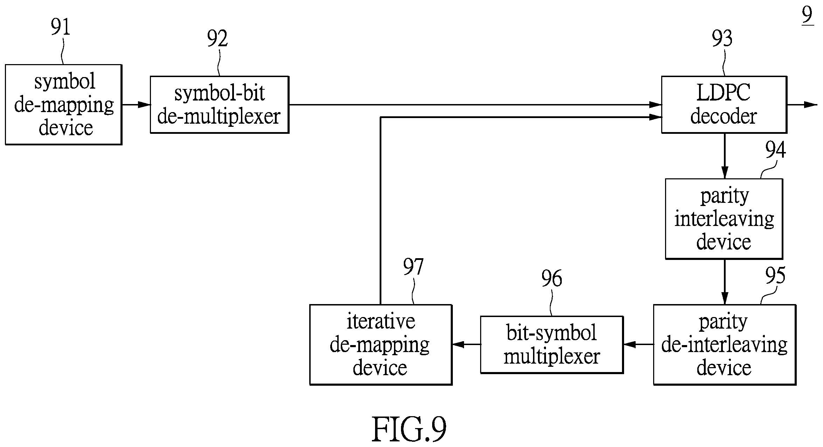

Referring to FIG. 9, FIG. 9 is an equivalent block diagram of an iterative de-mapping and decoding device adopting a QPSK modulation scheme with one other coding rate (without the 1/3 and 2/5 coding rate) according to an exemplary embodiment of the present disclosure. In this mode, the iterative de-mapping and decoding device 1 in FIG. 1 can be equivalently the same as the iterative de-mapping and decoding device 9 in FIG. 9. The equivalent iterative de-mapping and decoding device 9 comprises a symbol de-mapping device 91, a symbol-bit de-multiplexer 92, a LDPC decoder 93, a parity interleaving device 94, a parity de-interleaving device 95, a bit-symbol multiplexer 96, and an iterative de-mapping device 97.

The LDPC decoder 93 outputs the M first feedback LLRs and the M second feedback LLRs to the iterative de-mapping device 97. The iterative de-mapping device 97 solves the M LLRs which are served as initial values of the M LLRs input to the LDPC decoder 93 the next time. The M·(N-1) LLRs should not be permuted, but the M·(N-1) first feedback LLRs and the M·(N-1) second feedback LLRs output form the LDPC decoder 74 should be permuted in the second buffer corresponding to the bit-symbol multiplexing process since the transmitter does not perform a parity interleaving process and a column twist interleaving process.

It is noted that, since the LDPC decoder 93 and the parity interleaving device 94 may generally be integrated in one device, the M·(N-1) first feedback LLRs and the M·(N-1) second feedback LLRs should be permuted in the second buffer further corresponding to the parity de-interleaving process. That is, the second memory control unit calculates the second and third addresses to accordingly read the M·(N-1) first feedback LLRs and the M·(N-1) second feedback LLRs from the second memory, and then buffers them in the second buffer, such that the M·(N-1) first feedback LLRs and the M·(N-1) second feedback LLRs buffered in second buffer are thus permuted corresponding to the parity de-interleaving process and the bit-symbol multiplexing process.

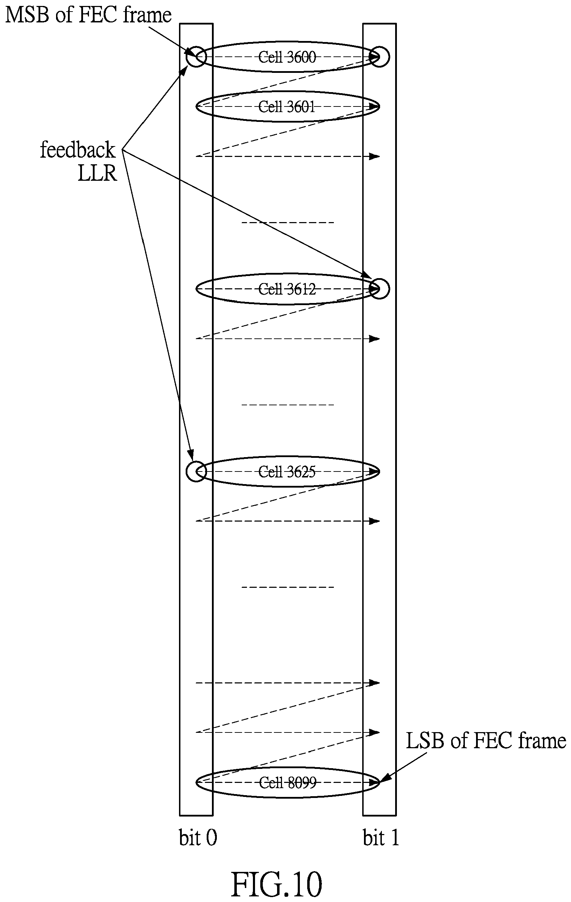

Referring to FIG. 10, FIG. 10 is a schematic diagram showing a parity de-interleaving process and a bit-symbol multiplexing process performed on first or second feedback LLRs of the parity part according to an exemplary embodiment of the present disclosure. FIG. 10 merely depicts the first feedback LLRs and the second feedback LLRs of the parity part are performed with the parity de-interleaving process and the bit-symbol multiplexing process, and the details that the parity de-interleaving process and the bit-symbol multiplexing process on the first feedback LLRs and the second feedback LLRs of the information part are the same as those shown in FIG. 8, thus omitting the redundant descriptions. As shown in FIG. 10, the parity de-interleaving process and the bit-symbol multiplexing process are used to parallel store the first and second feedback LLRs of the FEC frame to a first column through a second column several times, and calculate correct positions of the symbol which the first and feedback LLRs are output according to a value of Q_ldpc, wherein Q_ldpc is a parameter related to a coding rate of LDPC coding. For example, Q_ldpc is assumed to be 25, and when the start position of the symbol firstly output is the bit 0 of the symbol Cell 3600, the start position of the symbol next output is the bit 1 of the symbol Cell 3612.

Through the illustration of the parity de-interleaving process and a bit-symbol multiplexing process, the second memory control unit is designed to calculate the second and third addresses according to the above process, read the M·(N-1) first feedback LLRs and the M·(N-1) second feedback LLRs from the second memory according to the second and third addresses, and buffer them to the second buffer. In short, the iterative de-mapping and decoding device provided by the exemplary embodiment provided by the exemplary embodiment of the present disclosure can permute the M·(N-1) first feedback LLRs and the M·(N-1) second feedback LLRs without disposing the physical parity de-interleaving device and the physical bit-symbol multiplexer.

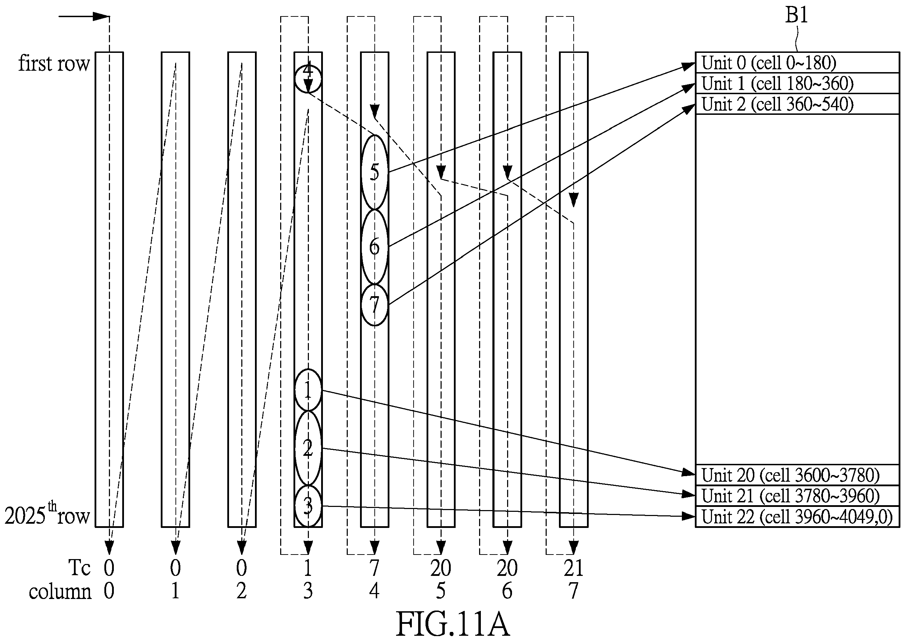

Referring to FIG. 11A, FIG. 11A is a schematic diagram showing a data reading process of the first memory according to an exemplary embodiment of the present disclosure. The first memory B1 has a plurality of memory units Unit 0 through Unit 22, and each memory unit can store 181 symbols. In FIG. 11A, if M is equal to 360, in the worst case, the memory units Unit 20 through 22 and Unit 0 through 2 may be read (i.e. six read operations) when reading the M in-phase signal values, the M quadrature signal values, and the M pieces of the channel state information.

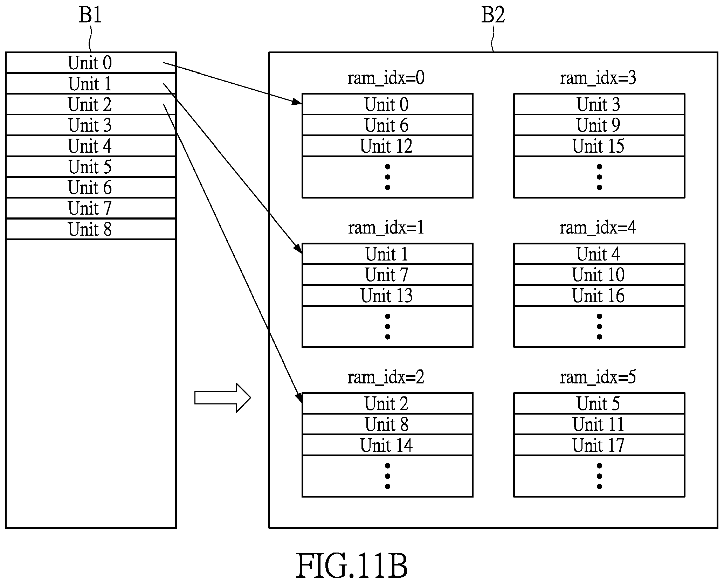

To decreasing the read time, the first memory can optionally be divided to first memory groups. Referring to FIG. 1B,FIG. 11B is a schematic diagram showing that a first memory is divided to several first memory group blocks according to an exemplary embodiment of the present disclosure. In FIG. 11B, the first memory B2 is divided to first memory groups, the index values ram_idx of the first memory groups are not the same one, and the first memory groups have different memory units, for example the first memory group with the index value being 0 has the memory units Unit 0, Unit 6, and Unit 12. Each first memory group can read the data of the memory units once.

Taking the worst case as that in FIG. 11A as an example, the first memory groups with index values being 0 through 4 in FIG. 11B are read, and thus one read operation is saved. Entirely, compared with the first memory B 1 in FIG. 11A, the first memory B2 in the general case has little read operations. In addition, in the similar manner, the second memory can be divided to second memory groups to decrease the read operations.

Accordingly, compared with the conventional iterative de-mapping and decoding device, the iterative de-mapping and decoding device provided by an exemplary embodiment of the present disclosure has little hardware cost, and can be implemented simply. On other hands, to reduce the number which the memory is read and to increase the speed of iterative de-mapping and decoding, the memory can be divided to several memory groups.

The above-mentioned descriptions represent merely the exemplary embodiment of the present disclosure, without any intention to limit the present disclosure which is limited only by the appended claims.

**Claims**

1. An iterative de-mapping and decoding device (1) comprising:

   a symbol de-interleaving device (10) receiving a forward error correction, FEC, frame comprising symbols, and performing a symbol de-interleaving process on M symbols, so as to output in-phase signal values, quadrature signal values, and pieces of the channel state information of the M symbols on which the symbol de-interleaving process is performed;
   a low density parity check, LDPC, decoder receiving a log likelihood ratio, LLR, of each of M bits of the M symbols, and outputting first feedback LLRs of the M bits accordingly;

   a first memory (12);
   a reception control unit (11), coupled to the first memory (12), sequentially storing the in-phase signal values, the quadrature signal values, and the pieces of channel state information in the first memory (12);
   a first buffer (14);
   a first memory control unit (13), coupled to the first memory (12) and the first buffer (14), calculating first addresses, and accordingly parallel buffering M in-phase signal values, M quadrature signal values, and M pieces of channel state information of the M symbols stored in the first memory (12) to the first buffer (14);
   a second memory (18);
   a second buffer (16);
   a second memory control unit (17), coupled to the second memory (18) and the second buffer (16), parallel storing each M first feedback log likelihood ratios, LLRs, generated from the low density parity check, LDPC, decoder (19) in the second memory (18), and calculating second addresses to accordingly buffer $M \cdot (N-1)$ first feedback LLRs stored in the second memory (18) to the second buffer (16); a de-map processing unit (15), coupled to the first buffer (14) and the second buffer (16), reading the $M \cdot (N-1)$ first feedback LLRs from the second buffer (16), reading K in-phase signal values, K quadrature signal values, and K pieces of the channel state information from the first buffer (14), and solving a LLR of each of M specific bits according to the $M \cdot (N-1)$ first feedback LLRs, the K in-phase signal values, the K quadrature signal values, and the K pieces of the channel state information;

   wherein M is a number of the first feedback LLRs once generated by the LDPC decoder (19), N is a bit number of the symbol, and K is an integer less than or equal to M; and
   wherein the iterative de-mapping and decoding device (1) uses an address calculating manner to access the first feedback LLRs, such that the first feedback LLRs are permuted and buffered in the second buffer (16) corresponding to a column twist interleaving process, a bit-symbol multiplexing process, and/or a parity de-interleaving process.

2. The iterative de-mapping and decoding device (1) according to claim 1, wherein the second memory control unit (17) further stores each M second feedback LLRs generated from the LDPC decoder in the second memory (18), and calculating third addresses to accordingly buffer $M \cdot (N-1)$ second feedback LLRs stored in the second memory (18) to the second buffer (16); and the de-map processing unit (15) further reads the $M \cdot (N-1)$ second feedback LLRs from the second buffer (16), and solves the LLR of each of the M specific bits according to the $M \cdot (N-1)$ first feedback LLRs, the $M \cdot (N-1)$ second feedback LLRs, the K in-phase signal values, the K quadrature signal values, and the K pieces of the channel state information.

3. The iterative de-mapping and decoding device (1) according to claim 1, wherein the iterative de-mapping and decoding device (1) is adapted to a digital video broadcasting system of DVB-T2 standard.

4. The iterative de-mapping and decoding device (1) according to claim 3, wherein when the digital video broadcasting system adopts a 16-QAM, 64-QAM, or 256-QAM modulation scheme, K is equal to M, and each of the M specific bits is one bit of each of M symbols, an action that the second memory control unit (17) utilizes the calculated second addresses to read the M·(N-1) first feedback LLRs from the second memory (18), and buffers the read M·(N-1) first feedback LLRs to the second buffer (16), which is used to perform a column twist interleaving process and a bit-symbol multiplexing process on the first feedback LLRs of a forward correction error, FEC, frame to output M·(N-1) first feedback LLRs.

5. The iterative de-mapping and decoding device (1) according to claim 4, wherein the column twist interleaving process is used to parallel store the first feedback LLRs of the FEC frame to a first column through a last column several times, wherein the M first feedback LLRs are stored each time, and each column has one offset flag to determine a storage start point of the column.

6. The iterative de-mapping and decoding device (1) according to claim 5, wherein the bit-symbol multiplexing process is used to exchange the columns being performed with the column twist interleaving process.

7. The iterative de-mapping and decoding device (1) according to claim 3, wherein when the digital video broadcasting system adopts a QPSK modulation scheme with a 1/3 or 2/5 coding rate, K is equal to M/2, and the M specific bits are all bits of the K symbols, an action that the second memory control unit (17) utilizes the calculated second addresses to read the M·(N-1) first feedback LLRs from the second memory (18), and buffers the read M·(N-1) first feedback LLRs to the second buffer (16), which is used to perform a bit-symbol multiplexing process on the first feedback LLRs of a FEC frame to output M·(N-1) first feedback LLRs.

8. The iterative de-mapping and decoding device (1) according to claim 7, wherein the bit-symbol multiplexing process is used to parallel store the first feedback LLRs of the FEC frame to a first column through a second column several times.

9. The iterative de-mapping and decoding device (1) according to claim 3, wherein when the digital video broadcasting system adopts a QPSK modulation scheme with a coding rate other than a 1/3 and 2/5 coding rate, K is equal to M/2, and the M specific bits are all bits of the K symbols, an action that the second memory control unit (17) utilizes the calculated second addresses to read the M·(N-1) first feedback LLRs from the second memory (18), and buffers the read M·(N-1) first feedback LLRs to the second buffer (16), which is used to perform a parity de-interleaving process and a bit-symbol multiplexing process on the first feedback LLRs of a FEC frame to output M·(N-1) first feedback LLRs.

10. The iterative de-mapping and decoding device (1) according to claim 9, wherein the parity de-interleaving process and the bit-symbol multiplexing process are used to parallel store the first feedback LLRs of the FEC frame to a first column through a second column several times, and calculate a correct position of the symbol which the first feedback LLR is output according to a value of Q_ldpc, wherein Q_ldpc is a parameter related to a coding rate of LDPC coding.

11. The iterative de-mapping and decoding device (1) according to claim 1, wherein the first memory (12) is divided to several first memory groups, and the second memory (18) is divided to several second memory groups.

12. The iterative de-mapping and decoding device (1) according to claim 1, wherein at a same time, the reception control unit (11) is used to sequentially store the in-phase signal values, the quadrature signal values, and the pieces of the channel state information of a $(i+2)^{th}$ frame in the first memory (12), and the de-map processing unit (15) solves the LLR of each of M specific bits associated with a $(i+1)^{th}$ frame according to the M·(N-1) first feedback LLRs, the K in-phase signal values, the K quadrature signal values, and the K pieces of the channel state information associated with the $(i+1)^{th}$ frame, and outputs the LLR of each of M specific bits associated with the $(i+1)^{th}$ frame, wherein i is an integer.

**Patentansprüche**

1. Iterative De-Mapping- und Decodiervorrichtung (1) umfassend:

eine Symbol-Entschachtelungsvorrichtung (10), die einen Symbole umfassenden Vorwärtsfehlerkorrekturrahmen FEC empfängt und einen Symbol-Entschachtelungsprozess auf M Symbolen durchführt, um so In-Phase-Signalwerte, Quadratursignalwerte und Teile von der Kanalzustandsinformation der M Symbole, auf denen der Symbol-Entschachtelungsprozesses durchgeführt wird, auszugeben;

einen Low-Density-Parity-Check-Decoder LDPC, der ein Log-Wahrscheinlichkeits-Verhältnis LLR von jedem der M Bits der M Symbole empfängt und die ersten Rückkopplungs-LLRs der M Bits entsprechend ausgibt;

einen ersten Speicher (12);

eine Empfangssteuereinheit (11), die mit dem ersten Speicher (12) gekoppelt ist, sequentiell die In-Phase-Signalwerte, die Quadratursignalwerte und die Teile von der Kanalzustandsinformation im ersten Speicher (12) speichert;

einen ersten Puffer (14);

eine erste Speichersteuereinheit (13), die mit dem ersten Speicher (12) und dem ersten Puffer (14) gekoppelt ist, die ersten Adressen und entsprechend die parallele Pufferung von M In-Phasen-Signalwerten, M Quadratursignalwerten und den M Teilen von der Kanal-Zustandsinformation der in dem ersten Speicher (12) gespeicherten M Symbole zu dem ersten Puffer (14) berechnet;

einen zweiten Speicher (18);

einen zweiten Puffer (16);

eine zweite Speichersteuereinheit (17), die mit dem zweiten Speicher (18) und dem zweiten Puffer (16) gekoppelt ist, parallel jedes der M ersten Rückkopplungs-Log-Wahrscheinlichkeitsverhältnisse, LLRs, die von dem Low-Density-Parity-Check-Decoder LDPC (19) in dem zweiten Speicher (18) gespeichert wurden und zweite Adressen zu dem zweiten Puffer (16), entsprechend M·(N-1) erster, in dem zweiten Speicher (18) gespeicherter Rückkopplungs-LLRs berechnet, zu puffern; eine De-Map-Verarbeitungseinheit (15), die mit dem ersten Puffer (14) und dem zweiten Puffer (16) gekoppelt ist, die M·(N-1) ersten Rückkopplungs-LLRs aus dem zweiten Puffer (16) liest, K In-Phase-Signalwerte, K Quadratursignalwerten und K Teile von der Kanalzustandsinformation aus dem ersten Puffer (14) liest und eine LLR jedes der M spezifischen Bits entsprechend der M·(N-1) ersten Rückkopplung LLRs, der K In-Phase-Signalwerte, der K Quadratursignalwerte und der K Teile der Kanalzustandsinformation löst;

wobei M eine Anzahl der ersten Rückkopplungs-LLRs ist, die einmal durch den LDPC-Decoder (19) erzeugt wurden, N eine Bitzahl des Symbols ist und K ein Integer kleiner oder gleich M ist; und

wobei die iterative De-Mapping- und Decodiervorrichtung (1) eine Adressenberechnungsweise verwendet, um auf die ersten Rückkopplungs-LLRs zuzugreifen, so dass die ersten Rückkopplungs-LLRs in dem zweiten Puffer (16), entsprechend einem Spaltendrehungs-Verschachtelungsprozess einem Bit-Symbol-Multiplex-Prozess und/oder einem Paritäts-Entschachtelungsprozess, permutiert und gepuffert werden.

2. Iterative De-Mapping- und Decodiervorrichtung (1) nach Anspruch 1, wobei die zweite Speichersteuereinheit (17) ferner jede von dem LDPC-Decoder in dem zweiten Speicher (18) erzeugten M zweiten Rückkopplungs-LLRs speichert und dritte Adressen entsprechend M·(N-1) zweiten Rückkopplungs-LLRs, die in dem zweiten Speicher (18) gespeichert sind, zu dem zweiten Puffer (16) berechnet; und die De-Map-Verarbeitungseinheit (15) ferner die M·(N-1) zweiten Rückkopplungs-LLRs aus dem zweiten Puffer (16) liest und die LLR jedes der M spezifischen Bits entsprechend den M·(N-1) erste Rückkopplungs-LLRs, den M·(N-1) zweiten Rückkopplungs-LLRs, den K In-Phase-Signalwerten, den K Quadratursignalwerten und den K Teilen der Kanalzustandsinformation löst.

3. Iterative De-Mapping- und Decodiervorrichtung (1) nach Anspruch 1, wobei die iterative De-Mapping- und Decodiervorrichtung (1) ein digitales Videoübertragungssystem des DVB-T2-Standards ausbildet.

4. Die iterative De-Mapping- und Decodiervorrichtung (1) nach Anspruch 3, wobei, wenn das digitale Videoübertragungssystem ein 16-QAM, 64-QAM- oder 256-QAM-Modulationsschema annimmt, K gleich M ist und jedes der M spezifischen Bits ein Bit von jedem der M Symbole ist, eine Aktion, gemäß der die zweite Speichersteuereinheit (17) die berechneten zweiten Adressen verwendet, um die M·(N-1) ersten Rückkopplungs-LLRs aus dem zweiten Speicher (18) zu lesen, und die gelesenen M·(N-1) ersten Rückkopplungs-LLRs an den zweiten Puffer (16) zu puffern, verwendet, um einen Spaltendrehungs-Verschachtelungsprozess und einen Bit-Symbol-Multiplexprozess auf dem ersten Rückkopplungs-LLRs eines Vorwärtskorrekturfehlerrahmen FEC durchzuführen, um M·(N-1) erste Rückkopplung-LLRs auszugeben.

5. Iterative De-Mapping- und Decodiervorrichtung (1) nach Anspruch 4, wobei der Spaltendrehungs-Verschachtelungsprozess verwendet wird, um die ersten Rückkopplungs-LLRs des FEC-Rahmens parallel zu einer ersten Spalte durch eine letzte Spalte mehrmals zu speichern, wobei die M ersten Rückkopplungs-LLRs jedes Mal gespeichert werden, und jede Spalte eine Versatz-Markierung aufweist, um einen Speicherstartpunkt der Spalte zu ermitteln.

6. Iterative De-Mapping- und Decodiervorrichtung (1) nach Anspruch 5, wobei der Bit-Symbol-Multiplexprozess zum Austausch der mit dem Spaltendrehungs-Verschachtelungsprozess durchgeführten Spalten verwendet wird.

**7.** Iterative De-Mapping- und Decodiervorrichtung (1) nach Anspruch 3, wobei, wenn das digitale Videoübertragungssystem ein QPSK-Modulationsschema mit einer 1/3 oder 2/5 Codierungsrate annimmt, K gleich M/2 ist, und die M spezifischen Bits alle Bits der K Symbole sind, eine Aktion, gemäß der die zweite Speichersteuereinheit (17) die berechneten zweiten Adressen verwendet, um die M·(N-1) ersten Rückkopplungs-LLRs aus dem zweiten Speicher (18) zu lesen, und puffert die gelesenen M·(N-1) ersten Rückkopplungs-LLRs an den zweiten Puffer (16), der verwendet wird, um einen Bit-Symbol-Multiplexprozess auf den ersten Rückkopplungs-LLRs eines FEC-Rahmens durchzuführen, um M·(N-1) erste Rückkopplungs-LLRs auszugeben.

**8.** Iterative De-Mapping- und Decodiervorrichtung (1) nach Anspruch 7, wobei der Bit-Symbol-Multiplexprozess zum parallelen Speichern der ersten Rückkopplungs-LLRs des FEC-Rahmens zu einer ersten Spalte durch eine zweite Spalte mehrmals verwendet wird.

**9.** Iterative De-Mapping- und Decodiervorrichtung (1) nach Anspruch 3, wobei, wenn das digitale Videoübertragungssystem ein QPSK-Modulationsschema mit einer anderen Codierungsrate als einer 1/3 und 2/5 Codierungsrate annimmt, K gleich M/2 ist und die M spezifischen Bits alle Bits der K Symbole sind, eine Aktion, gemäß der die zweite Speichersteuereinheit (17) die berechneten zweiten Adressen ·zu dem zweiten Puffer (16) verwendet, um die M·(N-1) ersten Rückkopplungs-LLRs aus dem zweiten Speicher zu lesen (18) und die gelesenen M·(N-1) erste Rückkopplung LLR · puffert, der verwendet wird, um einen Paritäts-Entschachtelungsprozess durchzuführen, und einen Bit-Symbol-Multiplexprozess auf den ersten Rückkopplungs-LLRs eines FEC-Rahmen, um M·(N-1) ersten Rückkopplungs-LLRs auszugeben.

**10.** Iterative De-Mapping- und Decodiervorrichtung (1) nach Anspruch 9, wobei der Paritäts-Entschachtelungsprozess und der Bit-Symbol-Multiplexprozess verwendet werden, um die ersten Rückkopplungs-LLRs des FEC-Rahmens parallel zu einer ersten Spalte durch eine zweite Spalte mehrmals zu speichern und eine korrekte Position des Symbols, das die erste Rückkopplungs-LLR ausgibt entsprechend gemäß einem Wert von Q_ldpc berechnet, wobei Q_ldpc ein Parameter ist, der sich auf eine Codierungsrate der LDPC-Codierung bezieht.

**11.** Iterative De-Mapping- und Decodiervorrichtung (1) nach Anspruch 1, wobei der erste Speicher (12) in mehrere erste Speichergruppen aufgeteilt ist und der zweite Speicher (18) in mehrere zweite Speichergruppen aufgeteilt ist.

**12.** Iterative De-Mapping- und Decodiervorrichtung (1) nach Anspruch 1, wobei zur gleichen Zeit die Empfangssteuereinheit (11) verwendet wird, um sequentiell die In-Phase-Signalwerte, die Quadratursignalwerte und die Teile der Kanalzustandsinformation eines (i+2)ten Rahmens in dem ersten Speicher (12) zu speichern und die De-Map-Verarbeitungseinheit (15) die LLR jedes der M spezifischen Bits, die mit einem (i+1)ten Rahmen entsprechend den M·(N-1) ersten Rückkopplungs-LLRs, den K In-Phase-Signalwerten, den K-Quadratursignalwerten und den K Teilen der Kanalzustandsinformation, die dem (i+1)ten Rahmen zugeordnet sind, löst und die LLR jedes der M spezifischen Bits, die dem (i+1)ten Rahmen zugeordnet sind, ausgibt, wobei i ein Integer ist.

## Revendications

**1.** Dispositif de démappage et de décodage itératifs (1) comprenant :

un dispositif de désentrelacement de symboles (10) recevant une trame de correction d'erreur sans voie de retour, FEC, comportant des symboles, et mettant en oeuvre un processus de désentrelacement des symboles sur M symboles, afin de délivrer en sortie des valeurs de signal en phase, des valeurs de signal en quadrature et des éléments d'information relatifs à l'état du canal des M symboles sur lesquels est mis en oeuvre le processus de désentrelacement des symboles ;

un décodeur de contrôle de parité à faible densité, LDPC, recevant un logarithme du rapport de vraisemblance, LLR, de chacun de M bits des M symboles, et délivrant en conséquence en sortie des premiers logarithmes LLR de rétroaction des M bits ;

une première mémoire (12) ;
une unité de commande de réception (11), couplée à la première mémoire (12), stockant séquentiellement les valeurs de signal en phase, les valeurs de signal en quadrature et les éléments d'informations relatifs à l'état du canal de la première mémoire (12) ;
une première mémoire tampon (14) ;
une première unité de commande de mémoire (13), couplée à la première mémoire (12) et à la première mémoire tampon (14), calculant des premières adresses, et par conséquent, mettant en mémoire tampon, en parallèle, M valeurs de signal en phase, M valeurs de signal en quadrature et M éléments d'informations relatifs à l'état du canal des M symboles, stockés dans la première mémoire (12), sur la première mémoire tampon (14) ;

une seconde mémoire (18) ;

une seconde mémoire tampon (16) ;

une seconde unité de commande de mémoire (17), couplée à la seconde mémoire (18) et à la seconde mémoire tampon (16), stockant en parallèle chaque M premiers logarithmes du rapport de vraisemblance, LLR, de rétroaction, générés par le décodeur de contrôle de parité à faible densité, LDPC, (19), dans la seconde mémoire (18), et calculant des secondes adresses pour mettre en mémoire tampon, en conséquence, M·(N - 1) premiers logarithmes LLR de rétroaction stockés dans la seconde mémoire (18) sur la seconde mémoire tampon (16) ;

une unité de traitement de démappage (15), couplée à la première mémoire tampon (14) et à la seconde mémoire tampon (16), lisant les M·(N - 1) premiers logarithmes LLR de rétroaction à partir de la seconde mémoire tampon (16), lisant K valeurs de signal en phase, K valeurs de signal en quadrature et K éléments d'informations relatifs à l'état du canal à partir de la première mémoire tampon (14), et résolvant un logarithme LLR de chacun de M bits spécifiques selon les M·(N - 1) premiers logarithmes LLR de rétroaction, les K valeurs de signal en phase, les K valeurs de signal en quadrature et les K éléments d'information relatifs à d'état du canal ;

dans lequel « M » est un nombre des premiers logarithmes LLR de rétroaction une fois générés par le décodeur de contrôle LDPC (19), « N » est un nombre de bits du symbole, et « K » est un nombre entier inférieur ou égal à « M » ; et

dans lequel le dispositif de démappage et de décodage itératif (1) utilise une méthode de calcul d'adresses pour accéder aux premiers logarithmes LLR de rétroaction, de sorte que les premiers logarithmes LLR de rétroaction sont permutés et mis en mémoire tampon dans la seconde mémoire tampon (16) correspondant à un processus d'entrelacement à torsion de colonne, à un processus de multiplexage des symboles binaires, et/ou à un processus de désentrelacement de parité.

2. Dispositif de démappage et de décodage itératif (1) selon la revendication 1, dans lequel la seconde unité de commande de mémoire (17) stocke en outre chacun des M seconds logarithmes LLR de rétroaction générés à partir du décodeur de contrôle LDPC de la seconde mémoire (18), et calcule des troisièmes adresses en vue de mettre en mémoire tampon, en conséquence, M·(N - 1) seconds logarithmes LLR de rétroaction stockés dans la seconde mémoire (18), sur la seconde mémoire tampon (16) ; et dans lequel l'unité de traitement de démappage (15) lit en outre les M·(N - 1) seconds logarithmes LLR de rétroaction à partir de la seconde mémoire tampon (16), et résout le logarithme LLR de chacun des M bits spécifiques selon les M·(N - 1) premiers logarithmes LLR de rétroaction, les M·(N - 1) seconds logarithmes LLR de rétroaction, les K valeurs de signal en phase, les K valeurs de signal en quadrature et les K éléments d'information relatifs à d'état du canal.

3. Dispositif de démappage et de décodage itératif (1) selon la revendication 1, dans lequel le dispositif de démappage et de décodage itératif (1) est adapté à un système de diffusion vidéonumérique de norme DVB-T2.

4. Dispositif de démappage et de décodage itératif (1) selon la revendication 3, dans lequel, lorsque le système de diffusion vidéonumérique adopte un schéma de modulation 16-QAM, 64-QAM ou 256-QAM, K est égal à M, et chacun des M bits spécifiques est un bit de chacun de M symboles, dans lequel la seconde unité de commande de mémoire (17) utilise les secondes adresses calculées pour lire les M·(N - 1) premiers logarithmes LLR de rétroaction à partir de la seconde mémoire (18) et met en mémoire tampon les M·(N - 1) premiers logarithmes LLR de rétroaction lus sur la seconde mémoire tampon (16), ce qui est utilisé pour mettre en oeuvre un processus d'entrelacement à torsion de colonne et un processus de multiplexage de symboles binaires sur les premiers logarithmes LLR de rétroaction d'une trame de correction d'erreur sans voie de retour, FEC, en vue de délivrer en sortie M·(N - 1) premiers logarithmes LLR de rétroaction.

5. Dispositif de démappage et de décodage itératif (1) selon la revendication 4, dans lequel le processus d'entrelacement à torsion de colonne est utilisé pour stocker en parallèle les premiers logarithmes LLR de rétroaction de la trame de correction FEC, dans une première colonne et jusqu'à une dernière colonne, plusieurs fois, dans lequel les M premiers logarithmes LLR de rétroaction sont stockés à chaque fois, et chaque colonne présente un fanion de décalage pour déterminer un point de départ de stockage de la colonne.

6. Dispositif de démappage et de décodage itératif (1) selon la revendication 5, dans lequel le processus de multiplexage de symboles binaires est utilisé pour échanger les colonnes mises en oeuvre avec le processus d'entrelacement à torsion de colonne.

**7.** Dispositif de démappage et de décodage itératif (1) selon la revendication 3, dans lequel, lorsque le système de diffusion vidéonumérique adopte un schéma de modulation QPSK avec un taux de codage de 1/3 ou 2/5, K est égal à M/2, et les M bits spécifiques sont tous des bits des K symboles, dans lequel la seconde unité de commande de mémoire (17) utilise les secondes adresses calculées pour lire les M·(N - 1) premiers logarithmes LLR de rétroaction à partir de la seconde mémoire (18), et met en mémoire tampon les M·(N - 1) premiers logarithmes LLR de rétroaction lus, sur la seconde mémoire tampon (16), ce qui est utilisé pour mettre en oeuvre un processus de multiplexage de symboles binaires sur les premiers logarithmes LLR de rétroaction d'une trame de correction FEC, en vue de délivrer en sortie M·(N - 1) premiers logarithmes LLR de rétroaction.

**8.** Dispositif de démappage et de décodage itératif (1) selon la revendication 7, dans lequel le processus de multiplexage de symboles binaires est utilisé pour stocker en parallèle plusieurs fois les premiers logarithmes LLR de rétroaction de la trame de correction FEC dans une première colonne et jusqu'à une seconde colonne.

**9.** Dispositif de démappage et de décodage itératif (1) selon la revendication 3, dans lequel, lorsque le système de diffusion vidéonumérique adopte un schéma de modulation QPSK avec un taux de codage distinct d'un taux de codage de 1/3 et 2/5, K est égal à M/2, et les M bits spécifiques sont tous des bits des K symboles, dans lequel la seconde unité de commande de mémoire (17) utilise les secondes adresses calculées pour lire les M·(N - 1) premiers logarithmes LLR de rétroaction à partir de la seconde mémoire (18), et met en mémoire tampon les M· (N - 1) premiers logarithmes LLR de rétroaction lus, sur la seconde mémoire tampon (16), ce qui est utilisé en vue de mettre en oeuvre un processus de désentrelacement de parité et un processus de multiplexage de symboles binaires sur les premiers logarithmes LLR de rétroaction d'une trame de correction FEC, en vue de délivrer en sortie M·(N - 1) premiers logarithmes LLR de rétroaction.

**10.** Dispositif de démappage et de décodage itératif (1) selon la revendication 9, dans lequel le processus de désentrelacement de parité et le processus de multiplexage des symboles binaires sont utilisés pour stocker en parallèle plusieurs fois les premiers logarithmes LLR de rétroaction de la trame de correction FEC dans une première colonne et jusqu'à une seconde colonne, et pour calculer une position correcte du symbole que le premier logarithme LLR de rétroaction a délivré en sortie selon une valeur de Q_ldpc, dans lequel Q_ldpc est un paramètre connexe à un taux de codage de codage LDPC.

**11.** Dispositif de démappage et de décodage itératif (1) selon la revendication 1, dans lequel la première mémoire (12) est divisée en plusieurs premiers groupes de mémoires, et la seconde mémoire (18) est divisée en plusieurs seconds groupes de mémoires.

**12.** Dispositif de démappage et de décodage itératif (1) selon la revendication 1, dans lequel, au même moment, l'unité de commande de réception (11) est utilisée pour stocker séquentiellement les valeurs de signal en phase, les valeurs de signal en quadrature, et les éléments d' information relatifs à d'état du canal d'une (i + 2)$^{ième}$ trame de la première mémoire (12), et l'unité de traitement de démappage (15) résout le logarithme LLR de chacun de M bits spécifiques associés à une (i + 1)$^{ième}$ trame selon les M·(N - 1) premiers logarithmes LLR de rétroaction, les K valeurs de signal en phase, les K valeurs de signal en quadrature et les K éléments d'information relatifs à l'état du canal associés à la (i + 1)$^{ième}$ trame, et délivre en sortie le logarithme LLR de chacun de M bits spécifiques associés à la (i + 1)$^{ième}$ trame, où « i » est un nombre entier.

FIG.1

| input first frame | input second frame | input third frame |
|---|---|---|
| | decode first frame | decode second frame |
| | | output decoding result of first frame |

| first iterative calculation | second iterative calculation | • • • • • | $L^{th}$ iterative calculation |
|---|---|---|---|

| first sub-iterative calculation | waiting time period | second sub-iterative calculation | waiting time period | • • • • • | $N^{th}$ sub-iterative calculation |
|---|---|---|---|---|---|

| update first and second feedback LLRs corresponding to M bits | update LLRs of M bits |
|---|---|

FIG.2

FIG.3

EP 3 002 898 B1

41

symbol
de-mapping
device

42

symbol-bit
de-multiplexer

43

column twist
de-interleaving
device

44

parity
de-interleaving
device

45

LDPC
decoder

4

46

parity
interleaving
device

49

iterative
de-mapping
device

48

bit-symbol
multiplexer

47

column twist
interleaving
device

FIG.4

FIG.5

first row

M feedback LLRs

2025th row

column  0  1  2  3  4  5  6  7

M feedback LLRs

Cell 0          Cell 0
Cell 2          Cell 2

Cell 4048       Cell 4048

bit index value  0  1  2  3    0  1  2  3

FIG.6

EP 3 002 898 B1

FIG.7

MSB of FEC frame

M
feedback
LLRs

Cell 0

Cell 1

LSB of FEC frame

Cell 8099

bit 0          bit 1

FIG.8

91

92

9

symbol
de-mapping
device

symbol-bit
de-multiplexer

93

LDPC
decoder

94

parity
interleaving
device

97

96

95

iterative
de-mapping
device

bit-symbol
multiplexer

parity
de-interleaving
device

FIG.9

MSB of FEC frame

feedback
LLR

Cell 3600

Cell 3601

Cell 3612

Cell 3625

LSB of FEC frame

Cell 8099

bit 0

bit 1

FIG.10

EP 3 002 898 B1

first row

2025th row

Tc  0    0    0    1    7    20   20   21
column 0  1    2    3    4    5    6    7

B1

Unit 0 (cell 0~180)
Unit 1 (cell 180~360)
Unit 2 (cell 360~540)

Unit 20 (cell 3600~3780)
Unit 21 (cell 3780~3960)
Unit 22 (cell 3960~4049,0)

FIG.11A

FIG.11B

**EP 3 002 898 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2525495 A1